# FASCICULE DE BREVET EUROPEEN

(11) **EP 2 578 068 B1**
(45) Date de publication et mention de la délivrance du brevet: **02.11.2016**
(21) Numéro de dépôt: 11726881.3
(22) Date de dépôt: 18.05.2011
(51) Int. Cl.: H05K 3/10, H05K 3/32, H05K 1/18, H05K 1/09

(54) **PROCEDE DE MONTAGE DE COMPOSANTS ELECTRONIQUES OU ELECTRIQUES SUR UN SUPPORT DE CIRCUIT CONDUCTEUR D'ELECTRICITE**
VERFAHREN ZUM ANSCHLIESSEN ELEKTRISCHER ODER ELEKTRONISCHER KOMPONENTEN AN EINE HALTERUNG FÜR EINEN ELEKTRISCH LEITENDEN SCHALTKREIS
METHOD FOR CONNECTING ELECTRICAL OR ELECTRONIC COMPONENTS TO A SUPPORT OF AN ELECTRICALLY CONDUCTIVE CIRCUIT

(30) Priorité: 03.06.2010 FR 1054332
(43) Date de publication de la demande: 10.04.2013
(73) Titulaire: SINTEX NP, 69740 Genas (FR)
(72) Inventeur: GIRODON, Marlène, F-69740 Genas (FR); MULLER, Didier, F-73490 La Ravoire (FR)
(74) Mandataire: Thibault, Jean-Marc
(86) Numéro de dépôt international: PCT/FR2011/051119
(87) Numéro de publication internationale: WO 2011/151558

(56) Documents cités:
- EP-A1- 0 622 980
- US-A- 4 985 601
- US-A- 6 110 576
- US-A1- 2003 153 223

## Description

La présente invention concerne le domaine technique du montage de composants électroniques ou électriques sur un support au sens général présentant un circuit conducteur d'électricité.

L'objet de l'invention concerne plus précisément le domaine technique du montage de composants électroniques ou électriques, sur un circuit conducteur d'électricité en matériau polymère thermoplastique, réalisé sur un support obtenu de préférence par moulage.

De manière classique, les composants électroniques ou électriques sont montés sur un support présentant un circuit conducteur d'électricité. Depuis des développements récents, il a été proposé de réaliser un support intégrant des fonctions mécaniques et des fonctions électriques. Ainsi sont apparus les dispositifs moulés interconnectés (Molded Interconnected Devices) comportant un support moulé présentant une couche d'un matériau conducteur d'électricité mis en motif pour former un circuit conducteur d'électricité.

Une première technique connue consiste à réaliser par moulage une pièce en matériau polymère qui est soumis ensuite à une structuration par un faisceau laser afin de recevoir ensuite une métallisation sélective chimique ou électrolytique en vue de réaliser le circuit conducteur d'électricité. Une variante connue de ce procédé consiste à métalliser toute la pièce moulée et à assurer l'ablation de la métallisation par le faisceau laser afin de réaliser le circuit conducteur d'électricité.

Une autre technique connue consiste à réaliser une pièce moulée qui est ensuite surmoulée à l'aide d'une matière métallisable. Une opération de métallisation sélective chimique ou électrolytique permet ensuite de réaliser le circuit conducteur d'électricité.

Il est également connu une autre technique dit de moulage bimatière consistant à réaliser sur une pièce moulée, un surmoulage avec un polymère thermosplastique conducteur d'électricité permettant de réaliser directement le circuit conducteur d'électricité.

Quelque soit la technique de fabrication, le support ainsi réalisé est destiné au montage de composants électroniques ou électriques destinés à être connectés électriquement au circuit conducteur d'électricité. De manière classique, la liaison électrique entre les composants électroniques ou électriques et le circuit conducteur d'électricité est réalisée soit par soudure du type reflow ou apport de métal soit par l'intermédiaire d'un assemblage mécanique direct ou par un clip élastique. Dans le cas de la technique de moulage bimatière, les composants électroniques ou électriques sont placés dans le moule avant l'injection du polymère thermoplastique conducteur d'électricité, et sont ainsi surmoulés.

En pratique, il s'avère que la connexion électrique de composants électroniques ou électriques constitue une opération délicate à mener à bien et présente diverses limitations. Ainsi, la technique de soudure reflow permet la fixation de composants électroniques ou électriques uniquement sur une pièce présentant une géométrie en deux dimensions. Par ailleurs, l'assemblage mécanique des composants électroniques ou électriques devient de plus en plus difficile à réaliser en raison de la réduction des dimensions de ces composants. De plus, le surmoulage de composants électroniques ou électriques est impossible pour de nombreuses pièces présentant des géométries tridimensionnelles car ces composants ne peuvent pas être maintenus correctement dans le moule.

Le document US 2003/153223 décrit une méthode de montage de composants électroniques ou électriques munis de contacts électriques, sur un support présentant un circuit conducteur d'électricité réalisé en un matériau plastique. Ce procédé consiste à chauffer le matériau plastique en relation des contacts électriques pour obtenir une soudure entre les contacts et le support. Selon une variante de réalisation, l'opération de chauffage est réalisée par l'application d'ondes ultrasonores engendrant des vibrations. Le maintien en position des composants lors de l'application des ondes ultrasonores est réalisé à l'aide d'un calibre de positionnement adapté à chaque composant.

Il est également connu, notamment par la demande de brevet US 2008/0086876, de réaliser une connexion électrique entre notamment, un circuit flexible et une antenne, en utilisant une encre conductrice qui est déposée sur un substrat isolant avant d'être soumis à une élévation de température par application d'ultrasons. Cette technique ne permet pas de fixer des composants électroniques ou électriques de manière simple et efficace sur un circuit.

La présente invention vise à remédier aux inconvénients de l'état de la technique en proposant une nouvelle technique permettant d'assurer de manière simple et efficace, une connexion électrique de composants électriques ou électroniques sur le circuit conducteur d'électricité de géométrie bi ou tridimensionnelle d'un support avantageusement moulé.

Pour atteindre un tel objectif, l'objet de l'invention concerne un procédé de montage de composants électroniques ou électriques munis de contacts électriques, sur un support présentant un circuit conducteur d'électricité.

Selon l'invention, on :
- réalise le circuit conducteur d'électricité par moulage d'un matériau polymère thermoplastique conducteur d'électricité,
- aménage un logement au moins en partie dans le circuit conducteur d'électricité,
- prépositionne le composant dans le logement en plaçant les contacts électriques au moins en partie en contact avec ledit circuit conducteur d'électricité,
- soumet au moins le composant à des vibrations ultrasonores pour assurer le soudage des contacts du composant avec le circuit conducteur d'électricité.

De plus, le procédé de montage selon l'invention peut présenter en outre en combinaison au moins l'une et/ou l'autre des caractéristiques additionnelles suivantes :
- réaliser le logement avec un profil d'emboîtement pour le composant,
- réaliser le logement en laissant subsister pour chaque contact électrique, une interface de matériau polymère séparé l'un de l'autre par une zone d'isolation électrique,
- réaliser le circuit conducteur d'électricité avec une épaisseur comprise dans une gamme allant de 0,25 mm à 3 mm,
- appliquer les vibrations ultrasonores en soumettant le composant à une force d'appui maîtrisée comprise entre 1 et 3 bars,
- appliquer les vibrations ultrasonores à une fréquence comprise entre 20 et 50 KHz,
- appliquer les vibrations ultrasonores avec une amplitude comprise entre 20 et 50 µm,
- appliquer les vibrations ultrasonores à l'aide d'une sonotrode de forme adaptée à la forme du composant.

Un autre objet de l'invention vise à proposer un support présentant un circuit conducteur d'électricité en matériau polymère thermoplastique conducteur d'électricité et obtenu par le procédé conforme à l'invention.

Selon l'invention, le support comporte au moins un composant monté dans un logement de prépositionnement et dont les contacts électriques sont fixés, sans apport de matière, au circuit conducteur d'électricité.

De plus, le support selon l'invention peut présenter pour chaque logement de prépositionnement, des interfaces de matériau polymère pour chaque contact électrique du composant, séparés entre eux par une zone d'isolation électrique.

Diverses autres caractéristiques ressortent de la description faite ci-dessous en référence aux dessins annexés qui montrent, à titre d'exemples non limitatifs, des formes de réalisation de l'objet de l'invention.
La **Figure 1** est une vue en perspective d'un exemple de réalisation d'un support équipé de composants électroniques ou électriques fixés selon le procédé conforme à l'invention.
La **Figure 2** est une vue en coupe élévation montrant le principe général de soudure de composants électroniques ou électriques sur un support.
La **Figure 3** est une vue en plan montrant un détail caractéristique du support conforme à l'invention.
La **Figure 4** est une vue en coupe transversale prise sensiblement sur la ligne IV-IV de la **Fig. 3****.**
Les **Figures 5, 6** et **7** sont des vues partielles en perspective montrant trois étapes caractéristiques du procédé de montage selon l'invention, à savoir le prépositionnement du composant sur le support, l'application d'ondes ultrasonores sur le composant, et le montage final du composant sur le support.
La **Figure 8** est une vue schématique en perspective montrant le montage d'un composant à connexions saillantes sur un support.

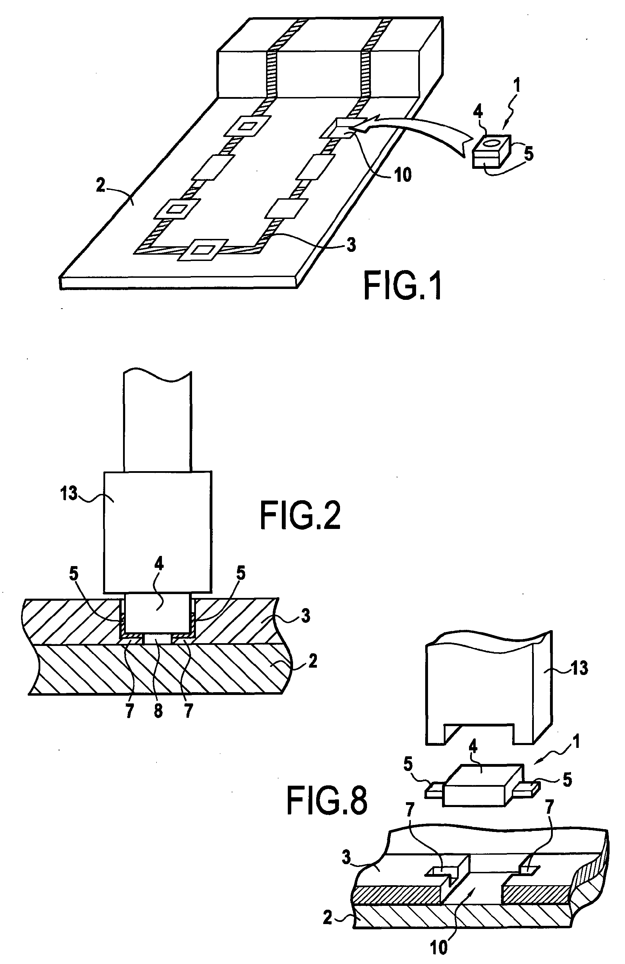

Tel que cela ressort plus précisément des **Fig. 1** et **2****,** l'objet de l'invention concerne un procédé permettant le montage de composants électriques ou électroniques **1** sur un support **2** présentant un circuit conducteur d'électricité **3.** Le support **2** se présente sous la forme d'une pièce réalisée en deux ou trois dimensions par les techniques classiques de moulage. Ce support **2** présente toutes les formes possibles pour intégrer avantageusement les fonctions mécaniques et/ou électriques, dépendantes des diverses applications ou utilisations envisageables pour un tel support. Par exemple, un tel support **2** est réalisé dans un matériau substrat permettant thermiquement le surmoulage du matériau constitutif du circuit conducteur d'électricité **3.** Préférentiellement et sans que cela puisse être limitatif, le matériau substrat est un polymère thermoplastique ou thermodurcissable.

Le support **2** est pourvu d'un circuit conducteur d'électricité **3** réalisé avantageusement lors d'une opération de moulage avec un matériau polymère thermoplastique conducteur d'électricité. Le support **2** est donc obtenu par une première opération de moulage, à la forme souhaitée, suivie par une opération de surmoulage avec un matériau polymère thermoplastique conducteur d'électricité mis en motif afin de réaliser le circuit conducteur d'électricité **3.** L'opération de surmoulage du matériau polymère thermoplastique conducteur d'électricité sur le support **2** est réalisée en effectuant une opération de thermoformage, d'injection ou de compression.

Bien entendu, le circuit conducteur d'électricité **3** peut correspondre à un ou plusieurs circuits conducteurs d'électricité indépendants présentant une géométrie bi ou tridimensionnelle et comportant en particulier une ou plusieurs pistes conductrices d'électricité.

Le circuit conducteur d'électricité **3** est réalisé par un matériau polymère thermoplastique conducteur d'électricité. Ce matériau à caractère thermofusible est par exemple réalisé par un matériau polymère thermoplastique chargé de particules conductrices d'électricité (métaux, graphite, noir de carbone, etc.). Par exemple, il peut être surmoulé le polymère thermoplastique commercialisé par la Société A. SCHULMAN S.A.S. (FR) sous la dénomination SCHULATEC^{®} Tin CO 50 Naturel.

Les composants **1** à fixer sur le support **2** sont de tous types connus en soi tel que par exemple des diodes, des résistances, des capteurs, des connecteurs, des fils de connexion, etc..

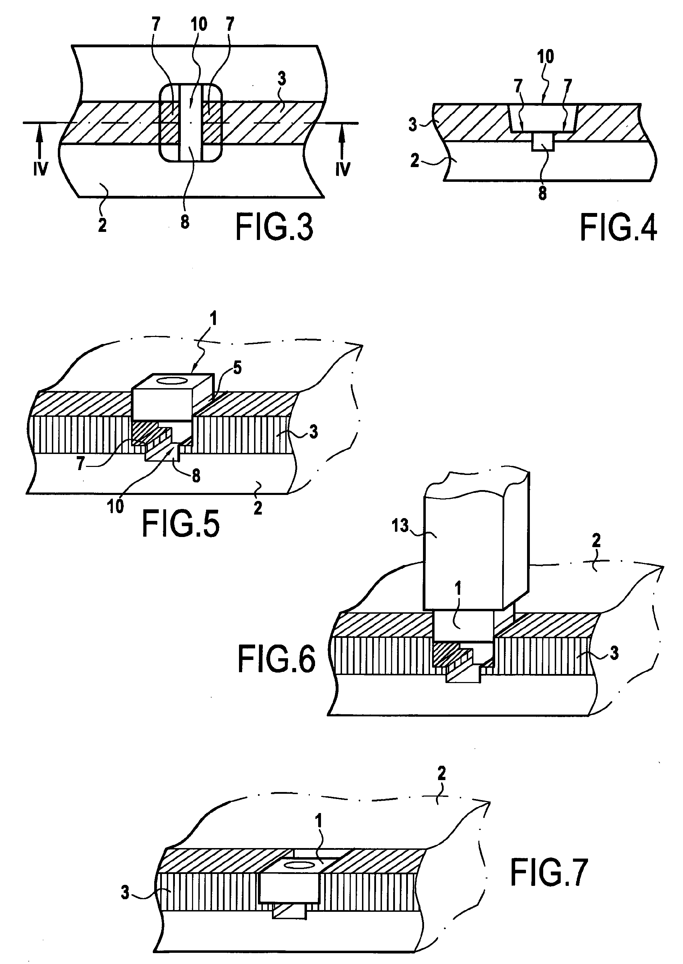

Les composants électroniques ou électriques **1** peuvent être des composants montés en surface (CMS) ou des composants de natures différentes. De manière classique, chaque composant électronique ou électrique **1** comporte un corps **4** et des contacts électriques **5** en général métalliques destinés à être reliés électriquement au moins en partie avec le circuit conducteur d'électricité **3.** De manière plus précise, les contacts électriques **5** sont destinés à être reliés à des zones de raccordement **7** du circuit conducteur d'électricité **3,** séparées l'une de l'autre par une zone d'isolation électrique **8 (****Fig. 3** à **5** et **Fig. 8****).**

Dans l'exemple illustré aux **Fig. 1** à **7****,** les contacts électriques **5** sont accolés au corps **4** du composant **1** qui est du type CMS alors que dans l'exemple illustré à la **Fig. 8****,** les contacts électriques **5** s'étendent en saillie par rapport au corps **4** du composant **1.**

L'objet de l'invention vise à proposer un procédé de montage des composants **1** assurant la connexion électrique des composants **1** avec le circuit conducteur d'électricité **3.** Le procédé selon l'invention consiste à placer les contacts électriques **5** du composant **1** au moins en partie en contact avec le circuit conducteur d'électricité **3** et en particulier avec les zones de raccordement **7.** Le procédé selon l'invention consiste ensuite à soumettre au moins le composant **1** à des vibrations ultrasonores pour assurer le soudage des contacts électriques **5** avec le circuit conducteur d'électricité **3.**

Le composant **1** et en particulier les contacts électriques **5** sont soumis à des vibrations conduisant à une élévation de température à l'interface entre les contacts électriques **5** et le circuit conducteur d'électricité **3.** Il s'ensuit une thermofusion du polymère thermoplastique conducteur d'électricité et une soudure entre les contacts électriques **5** et le circuit conducteur d'électricité **3.**

Selon une caractéristique avantageuse de réalisation, le procédé selon l'invention consiste, avant d'appliquer les vibrations ultrasonores aux composants **1,** à prépositionner le composant **1** dans un logement **10** de manière à être maintenu en position pour éviter son mouvement, ou éjection, lors de l'application des vibrations ultrasonores. Ainsi, le procédé selon l'invention vise à aménager un logement **10** en partie ou totalement dans le circuit conducteur d'électricité **3** pour permettre le prémontage du composant **1.** Ainsi, ce logement de prépositionnement **10** est adapté à la forme du corps **4** et/ou des contacts électriques **5** du composant **1.** Ainsi, le composant **1** à savoir le corps **4** et/ou les contacts électriques **5** se trouvent encastrés ou bloqués en partie ou totalement à l'intérieur du logement **10.**

Les **Fig. 3** à **5** illustrent un exemple de montage d'un composant **1** du type CMS présentant une forme générale parallélipédique avec des contacts électriques **5** s'étendant de part et d'autre de ses deux faces opposées et sur le fond du corps **4.** Selon cet exemple, le logement **10** présente une forme parallélépipédique adaptée à la forme du composant **1.** Bien entendu, le logement **10** peut présenter une forme adaptée à une partie seulement du composant **1.** Dans le même sens, le logement **10** peut présenter une ou plusieurs parties communiquant ou non entre elles.

Selon une variante préférée de réalisation, le logement **10** est réalisé avec un profil d'emboîtement pour le composant **1** permettant d'obtenir son auto-maintien à l'intérieur du logement lors de son insertion. Comme cela apparaît plus précisément à la **Fig. 4****,** le logement **10** possède un profil avantageusement conique ou trapézoïdal permettant au composant **1** d'être maintenu dans une position fixe et stable dans le support **2.** Le composant **1** se trouve ainsi bloqué en position à l'intérieur du logement **10.** Le composant **1** est positionné à l'aide de tous types d'outils de préhension connus en soi.

Selon une caractéristique avantageuse, le composant **1** est placé dans une position correspondant pratiquement à sa position finale de fixation. Dans le cas d'un composant **1** du type CMS, le logement **10** est réalisé de manière par exemple que son corps **4** est sensiblement affleurant à la surface supérieure du support **2.**

Avantageusement, le logement **10** est aménagé pour délimiter des zones de raccordement **7** présentant une épaisseur de matériau inférieur à la couche de matériau réalisant le circuit conducteur d'électricité 3. Tel que cela ressort plus précisément de la **Fig**. **4** notamment, chaque zone de raccordement **7** laisse subsister une interface ou un épaulement de matériau polymère thermoplastique conducteur d'électricité d'une épaisseur réduite par exemple comprise entre 20 et 50 % de l'épaisseur totale du circuit conducteur d'électricité **3.**

Selon une caractéristique de l'invention, le circuit conducteur d'électricité **3** présente une épaisseur supérieure ou égale à 0,25 mm. De préférence, l'épaisseur du circuit conducteur d'électricité est comprise dans une gamme allant de 0,25 mm à 3 mm.

Dans l'exemple illustré, le logement **10** est réalisé pour déborder de part et d'autre du circuit conducteur d'électricité **3,** mais il est clair que le logement **10** présente une forme adaptée pour permettre l'insertion du corps **4** du composant **1** dans le support **2.**

Le montage des composants **1** sur un support **2** découle directement de la description qui précède.

Les logements **10** sont aménagés sur le support **1** de manière à permettre la réception des composants **1.** Les logements **10** sont réalisés pour permettre de présenter des zones de raccordement **7** et des zones d'isolation électriques **8.** Ces logements **10** sont réalisés en toute matière appropriée et sont obtenus par exemple par usinage ou par moulage.

Les composants **1** sont positionnés à l'intérieur des logements **10 (****Fig. 5****)** par tout système de positionnement et de préhension connu en soi. Une fois que le composant **1** se trouve positionné dans son logement **10,** des vibrations ultrasonores sont appliquées au composant **1.** La chaleur engendrée par le frottement de l'interface entre les contacts électriques **5** du composant **1** et le circuit conducteur d'électricité **3,** conduit à la fusion du polymère thermoplastique conducteur d'électricité et permet la soudure du composant **1** avec le circuit conducteur d'électricité **3.** Cette soudure est obtenue sans apport de matière extérieure.

Il est à noter que les vibrations ultrasonores sont appliquées grâce à une sonotrode **13** faisant partie d'un dispositif de soudure par ultrasons connu en soi. La sonotrode **13** présente une forme adaptée à la forme du composant **1** à souder de manière que les vibrations ultrasonores se trouvent appliquées avantageusement et principalement sur les contacts électriques **5** du composant **1.**

Dans l'exemple illustré aux **Fig. 3** à **7****,** visant le soudage d'un composant **1** du type CMS, la sonotrode **13** utilisée est une sonotrode plate destinée à être en contact avec le corps **4** du composant **1.** La **Fig. 8** illustre un autre exemple de réalisation dans lequel les contacts électriques **5** du composant **1** s'étendent en saillie par rapport au corps **4** du composant **1.** Dans ce cas, la sonotrode **13** présente une forme en **U** permettant d'être en contact principalement avec les contacts électriques **5** du composant **1.**

Selon une caractéristique avantageuse de réalisation, les vibrations ultrasonores sont appliquées pour soumettre le composant **1** à une force d'appui maîtrisée comprise entre 1 et 3 bars. Cette force d'appui qui est relativement faible n'a pas pour but d'enfoncer le composant **1** dans le logement **10,** mais de maintenir le composant en positon fixe pendant le temps de la fusion du matériau polymère thermoplastique.

Selon une autre caractéristique de l'invention, les vibrations ultrasonores présentent une fréquence comprise entre 20 et 50 Khz.

Selon une autre variante de réalisation avantageuse du procédé conforme à l'invention, les vibrations ultrasonores sont appliquées avec une amplitude comprise entre 20 et 50 µm. Cette amplitude correspond à la distance de martèlement lors de l'opération de soudure par ultrasons.

## Revendications

1. Procédé de montage de composants électroniques ou électriques **(1)** munis de contacts électriques (**5**), sur un support **(2)** présentant un circuit conducteur d'électricité (**3**), selon lequel :
- réalise le circuit conducteur d'électricité par moulage d'un matériau polymère thermoplastique conducteur d'électricité,
- aménage un logement **(10)** au moins en partie dans le circuit conducteur d'électricité **(3),**
- prépositionne le composant **(1)** dans le logement **(10)** en plaçant les contacts électriques **(5)** au moins en partie en contact avec ledit circuit conducteur d'électricité,
- soumet au moins le composant (**1**) à des vibrations ultrasonores pour assurer le soudage des contacts **(5)** du composant (**1**) avec le circuit conducteur d'électricité, **caractérisé en ce qu'**il consiste à réaliser le logement **(10)** avec un profil d'emboîtement pour le composant (**1**) et en laissant subsister pour chaque contact électrique **(5),** une interface **(7)** de matériau polymère séparé l'un de l'autre par une zone d'isolation électrique (**8**), et présentant une épaisseur comprise entre 20 et 50 % de l'épaisseur totale du circuit conducteur d'électricité (3).

2. Procédé selon la revendication 1, **caractérisé en ce qu'**il consiste à réaliser le circuit conducteur d'électricité avec une épaisseur comprise dans une gamme allant de 0,25 mm à 3 mm.

3. Procédé selon la revendication 1, caractérisé à ce qu'il consiste à appliquer les vibrations ultrasonores en soumettant le composant à une force d'appui maîtrisée comprise entre 1 et 3 bars.

4. Procédé selon l'une des revendications 1 à 2, **caractérisé en ce qu'**il consiste à appliquer les vibrations ultrasonores à une fréquence comprise entre 20 et 50 KHz.

5. Procédé selon l'une des revendications 1 à 4, **caractérisé en ce qu'**il consiste à appliquer les vibrations ultrasonores avec une amplitude comprise entre 20 et 50 µm.

6. Procédé selon l'une des revendications 1 à 5, **caractérisé en ce qu'**il consiste à appliquer les vibrations ultrasonores à l'aide d'une sonotrode de forme adaptée à la forme du composant **(1).**

7. Support **(2)** présentant un circuit conducteur d'électricité **(3)** en matériau polymère thermoplastique conducteur d'électricité et obtenu par le procédé conforme à l'une des revendications 1 à 6, **caractérisé en ce qu'**il comporte au moins un composant **(1)** monté dans un logement **(10)** de prépositionnement et dont les contacts électriques (**5**) sont fixés, sans apport de matière, au circuit conducteur d'électricité (**3**), chaque logement de prépositionnement (**10**) comportant des interfaces (**7**) de matériau polymère pour chaque contact électrique du composant, séparés entre eux par une zone d'isolation électrique (**8**) et présentant une épaisseur comprise entre 20 et 50 % de l'épaisseur totale du circuit conducteur d'électricité (3).

## Patentansprüche

1. Verfahren zum Anschließen elektronischer oder elektrischer Komponenten (1), die mit elektrischen Kontakten (5) versehen sind, an einen Träger (2), der einen elektrisch leitenden Schaltkreis (3) aufweist, bei dem:
- der elektrisch leitende Schaltkreis durch Formen eines elektrisch leitenden thermoplastischen Polymermaterials hergestellt wird,
- eine Lagerung (10) zumindest teilweise in dem elektrisch leitenden Schaltkreis (3) vorgesehen wird,
- die Komponente (1) in der Lagerung (10) vorpositioniert wird, wobei die elektrischen Kontakte (5) zumindest teilweise in Kontakt mit der elektrisch leitenden Schaltung angeordnet werden,
- zumindest die Komponente (1) Ultraschallschwingungen ausgesetzt wird, um das Verschweißen der Kontakte (5) der Komponente (1) mit der elektrisch leitenden Schaltung zu gewährleisten,
**dadurch gekennzeichnet, dass** es darin besteht, die Lagerung (10) mit einem Einsetzprofil für die Komponente (1) herzustellen, wobei für jeden elektrischen Kontakt (5) eine Schnittstelle (7) aus Polymermaterial bestehen bleibt, die voneinander durch eine elektrisch isolierende Zone (8) getrennt sind und eine Dicke zwischen 20 und 50% der Gesamtdicke der elektrisch leitenden Schaltung (3) aufweisen.

2. Verfahren nach Anspruch 1, **dadurch gekennzeichnet, dass** es darin besteht, die elektrisch leitende Schaltung mit einer Dicke herzustellen, die in einem Bereich von 0,25 mm bis 3 mm enthalten ist.

3. Verfahren nach Anspruch 1, **dadurch gekennzeichnet, dass** es darin besteht, die Ultraschallschwingungen anzuwenden, während die Komponente einer kontrollierten Auflagekraft zwischen 1 und 3 bar ausgesetzt ist.

4. Verfahren nach einem der Ansprüche 1 bis 2, **dadurch gekennzeichnet, dass** es darin besteht, die Ultraschallschwingungen mit einer Frequenz zwischen 20 und 50 KHz anzuwenden.

5. Verfahren nach einem der Ansprüche 1 bis 4, **dadurch gekennzeichnet, dass** es darin besteht, die Ultraschallschwingungen mit einer Amplitude zwischen 20 und 50 µm anzuwenden.

6. Verfahren nach einem der Ansprüche 1 bis 5, **dadurch gekennzeichnet, dass** es darin besteht, die Ultraschallschwingungen mit Hilfe einer Sonotrode von an die Form der Komponente (1) angepasster Form anzuwenden.

7. Träger (2), der eine elektrisch leitende Schaltung (3) aus elektrisch leitendem thermoplastischem Polymermaterial aufweist, die durch das Verfahren nach einem der Ansprüche 1 bis 6 erhalten wird, **dadurch gekennzeichnet, dass** er mindestens eine Komponente (1) umfasst, die in einer Lagerung (10) zur Vorpositionierung montiert ist, und deren elektrischen Kontakte (5) ohne Materialzufuhr an der elektrisch leitenden Schaltung (3) befestigt sind, wobei jede Lagerung (10) zur Vorpositionierung Schnittstellen (7) aus Polymermaterial für jeden elektrischen Kontakt der Komponente umfasst, die voneinander durch eine elektrisch isolierende Zone (8) getrennt sind und eine Dicke zwischen 20 und 50% der Gesamtdicke der elektrisch leitenden Schaltung (3) aufweisen.

## Claims

1. A method for connecting electrical or electronic components (1) provided with electrical contacts (5), onto a support (2) having an electrically conductive circuit (3), according to which:
- the electrically conductive circuit is made by molding an electrically conductive thermoplastic polymeric material,
- an accommodation (10) is at least partly made in the electrically conductive circuit (3),
- the component (1) is pre-positioned in the accommodation (10), by placing the electrical contacts (5) at least partly in contact with said electrically conductive circuit,
- the component (1) is at least subjected to ultrasonic vibrations to ensure the welding of the contacts (5) of the component (1) with the electrically conductive circuit,
**characterized in that** it consists of making the accommodation (10) with an interlocking profile for the component (1) and leaving for each electrical contact (5), an interface (7) of polymeric material separated from each other with an electrical insulation area (8), and having a thickness comprised between 20 and 50% of the total thickness of the electrically conductive circuit (3).

2. The method according to claim 1, **characterized in that** it consists of making the electrically conductive circuit with a thickness comprised in the range from 0.25 mm to 3 mm.

3. The method according to claim 1, **characterized in that** it consists of applying the ultrasonic vibrations while subjecting the component to a controlled pressure force comprised between 1 and 3 bars.

4. The method according to one of claims 1 to 2, **characterized in that** it consists of applying the ultrasonic vibrations at a frequency comprised between 20 and 50 kHz.

5. The method according to one of claims 1 to 4, **characterized in that** it consists of applying the ultrasonic vibrations with an amplitude comprised between 20 and 50 µm.

6. The method according to one of claims 1 to 5, **characterized in that** it consists of applying the ultrasonic vibrations by means of a sonotrode with a shape adapted to the shape of the component (1).

7. A support (2) having an electrically conductive circuit (3), in an electrically conductive thermoplastic polymeric material and obtained with the method according to one of claims 1 to 6, **characterized in that** it includes at least one component (1) mounted in a pre-positioning accommodation (10) and the electrical contacts (5) of which are attached, without any provision of material to the electrically conductive circuit (3), each pre-positioning accommodation (10) including polymeric material interfaces (7) for each electrical contact of the component, separated from each other with an electrically insulating area (8) and having a thickness comprised between 20 and 50% of the total thickness of the electrically conductive circuit (3).
